# EUROPEAN PATENT APPLICATION

(11) **EP 4 199 501 A1**
(43) Date of publication of application: **21.06.2023**
(21) Application number: 21214740.9
(22) Date of filing: 15.12.2021
(51) Int. Cl.: H04N 5/378, H03M 1/56, H04N 5/357

(54) **VOLTAGE RAMP GENERATOR WITH LOW-NOISE OFFSET INJECTION**

(71) Applicant: ams Sensors Belgium BVBA, 2600 Antwerpen (Berchem) (BE)
(72) Inventor: Ruythooren, Koen, 5656 AE Eindhoven (NL); De Wit, Pieter, 5656 AE Eindhoven (NL); Hashani, Besart, 5656 AE Eindhoven (NL)
(74) Representative: Epping - Hermann - Fischer

(57) **Abstract**

A voltage ramp generator with low-noise offset injection comprises an output node (O) to output an output voltage (VRAMP) of the voltage ramp generator, a current source (110) coupled to the output node (O), and an array of capacitors (120). Each of the capacitors (120a,..., 120n) has a respective first node (121) being coupled to the output node (O), and a respective second node (122). The voltage ramp generator is configured to selectively couple the respective second node (122) of at least a portion of the capacitors (120a, ..., 120m) of the array of capacitors (120) to one of a first voltage reference (VOFF, VOFF1) and a second voltage reference (GND, VOFF2).

## Description

### Technical Field

The disclosure relates to a voltage ramp generator with low-noise offset injection which may be used in an image sensor for converting analog signals of a pixel cell into digital values by a single-slope ramp analog-to-digital converter.

### Background

An image sensor comprises a plurality of pixel cells which are arranged in a pixel array in rows and columns. A pixel cell comprises a photodiode as a light-sensitive element which produces charge carriers in response to incident light. The charge carriers may be stored on an storage capacitor in the pixel cell.

Before reading out the pixel cell, a reset pulse is applied to the pixel cell in a reset phase to connect the storage capacitor to a supply potential. During the reset phase, a source follower transistor of the pixel cell provides a "reset voltage" on a column readout line indicating a charge stored on the storage capacitor during the reset phase. In a subsequent light detection phase, the photodiode of the pixel cell is connected to the storage capacitor, and, after an integration period, a transfer pulse is applied to the pixel cell. As a result, the source follower transistor provides a "signal voltage" on the column readout line. The "signal voltage" indicates a charge stored on the storage capacitor that is dependent from the incident light on the photodiode during the light detection phase.

During the reset phase, the resulting "reset voltage" on the column readout line is sampled, and during the light-sensitive phase the resulting "signal voltage" on the column readout line is also sampled. The sampled signals are processed to obtain a digital output signal representing a difference between the level of the "signal voltage" and the level of the "reset voltage".

In order to convert the "reset voltage" and the "signal voltage" into a respective digital signal, a single slope ramp ADC may be provided in the image sensor. The single slope ramp ADC uses a global ramp voltage to convert voltage signals on multiple column readout lines in parallel. The analog-to-digital converter is coupled to a ramp generator which may generate, for example, an increasing voltage level between a low voltage level and a high voltage level. The analog-to-digital converter comprises a comparator which compares the analog signal, i.e. the respective level of the "reset voltage" and the "signal voltage", to be digitized, on the column readout line to the ramp input voltage from the voltage ramp generator. The image sensor may comprise a counter circuit coupled to a latch that is responsive to a change in the output of the comparator to latch a current count value from the counter. Once the ramp voltage from the voltage ramp generator exceeds the voltage level on the column readout line, the comparator output voltage switches, causing the latch to hold the last counter value, which represents the digital value of the analog signal on the column readout line.

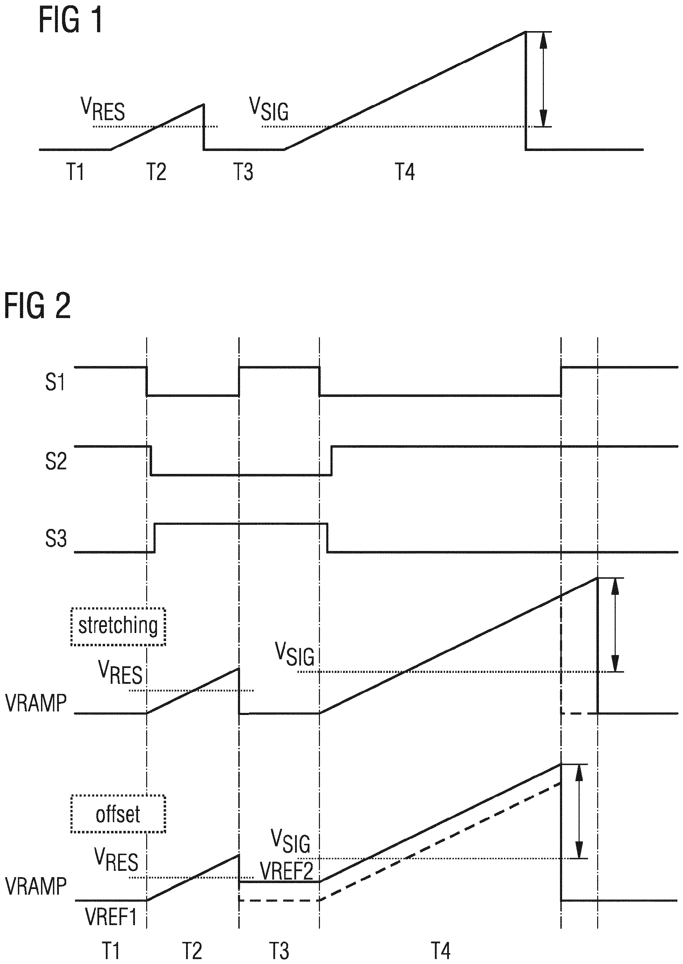

The "reset voltage" and the "signal voltage" on a column readout line are converted separately by the ramp ADC. The ramp voltage provided by the voltage ramp generator is usually reset between the two conversions. Figure 1 shows the course of a ramp voltage provided by a voltage ramp generator during a first initialization phase T1, the reset phase T2, a second initialization phase T3, and a light-sensitive phase T4. During the reset phase, the "reset voltage" VRES on the column readout line is sampled. During the light-sensitive phase a level of a "signal voltage" above a "dark voltage" level VSIG is sampled.

The level of the "dark voltage" represents the "signal voltage" on the column readout line during the light-sensitive phase of the pixel cell, when there is no incident light on the pixel cell. In most applications, pixels may have an intrinsic voltage offset between their "reset voltage" level and their "dark voltage" level. For a ramp analog-to-digital converter, if both reset and signal conversion ramps start at the same time (because the same reference and buffer is used) this offset is wasted time during the conversion. Especially with a large gain in the analog-to-digital converter (shallow ramp slope) the removal of the offset conversion time could significantly reduce conversion time and therefore decrease the maximum frame rate of an imager.

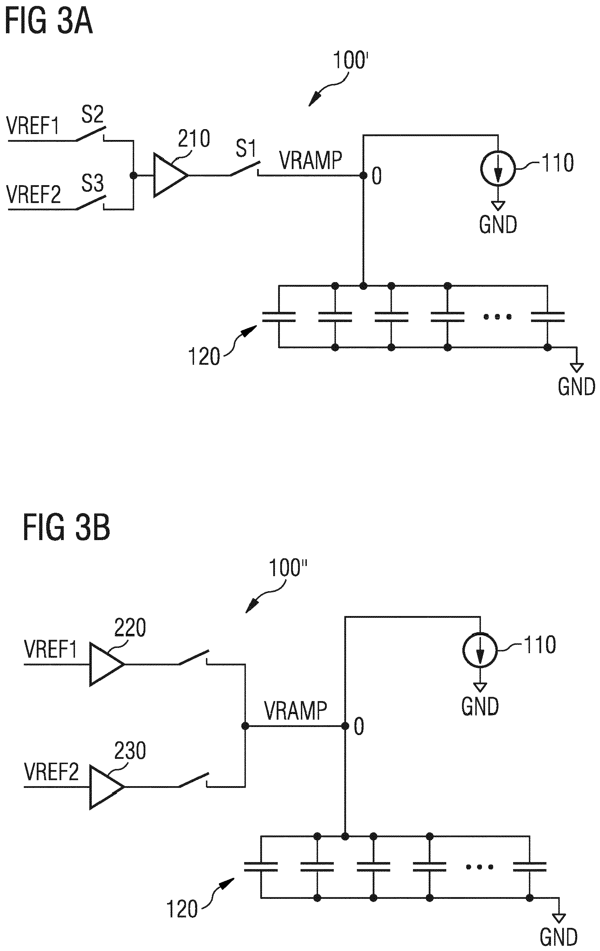

Figure 2 shows a timing diagram of control signals S1, S2 and S3 of controllable switches of a voltage ramp generator 100' shown in Figure 3A, and courses of voltage ramps to convert a "reset voltage" and a "signal voltage" of an image sensor. If there is a systematic offset between the "reset voltage" and the "dark voltage", either one of the ramps needs to be stretched during the light-sensitive phase T4, as shown in the stretched course of the ramp voltage in Figure 2, or the second ramp used to determine the "signal voltage" during the light-sensitive phase T4 should start at a different voltage level compared to the first ramp used to determine the "reset voltage" during the reset phase T1, as shown in the offset course of the ramp signal in Figure 2.

In principle, both options allow all signal voltages provided by a pixel cell during the light-sensitive phase to be detected. However, with conventional voltage ramp generators both of these solutions have negative issues.

Regarding the stretching technique, the stretched ramp timing decreases conversion rate. Regarding the offset technique, an offset may be created by initializing the ramp voltage during the initialization phases T1 and T3 to two different reference voltages. Figure 3A and Figure 3B show two possible configurations of a voltage ramp generator 100' and 100" to provide a voltage ramp VRAMP at an output node O, wherein the voltage ramp VRAMP may be initialized to a first voltage reference VREF1 or a second voltage reference VREF2. According to both configurations, the voltage generator 100', 100" comprises a current source 110 that is coupled to an array of capacitors 120 with capacitors 120a, ..., 120n. Initializing the ramp voltage to two different voltage references VREF1 and VREF2 can be done by using one buffer 210 (Figure 3A), or two buffers 220 and 230 (Figure 3B).

However, switching to a different reference for the two ramps, i.e. the "reset voltage" ramp and the "signal voltage" ramp, by the circuit configuration shown in Figure 3A, or changing the reference by using two buffers 220 and 230, as shown in the circuit configuration of Figure 3B, has a significant negative impact on noise, since the noise of the two references VREF1 and VREF2 is uncorrelated. In conclusion, the difference in noise between the two references VREF1 and VREF2 is seen as an extra signal in conversion. Moreover, if two buffers 220 and 230 are used to provide the two different reference voltages, also the noise of these buffers is added as an extra noise.

There is a desire to provide a voltage ramp generator having low-noise offset injection.

### Summary

An embodiment of a voltage ramp generator which enables to add an offset to a voltage ramp with minimal added noise is specified in claim 1.

A voltage ramp generator with low-noise offset injection comprises an output node to output an output voltage of the voltage ramp generator, a current source coupled to the output node and an array of capacitors. Each of the capacitors has a respective first node being coupled to the output node, and a respective second node. The voltage ramp generator is configured to selectively couple the respective second node of at least a portion of the capacitors of the array of capacitors to one of a first voltage reference and a second voltage reference.

According to the proposed approach of a voltage ramp generator, the offset of the voltage ramp can be injected by using only a part of the available capacitors of the array of capacitors of the voltage generator, and changing the reference voltage after the initialization of the ramp voltage. Since the injection only uses part of the available capacitors of the array of capacitors, the voltage difference between the first voltage reference and the second voltage reference is attenuated by the ratio of switching versus non-switching capacitors. The noise on the references is attenuated by this same ratio.

According to an embodiment, the voltage ramp generator comprises a first common node of the portion of the capacitors. The respective second node of the portion of the capacitors is connected to the first common node. The first common node is arranged to apply one of the first voltage reference and the second voltage reference.

According to the proposed embodiment of the voltage ramp generator, the portion of the capacitors is connected in parallel between the output node and the first common node. In particular, the respective first node of the capacitors coupled to the upper plate of the portion of capacitors is connected to the output node, and the respective second node coupled to the bottom plate of the portion of capacitors is connected to the first common node.

According to an embodiment, the voltage ramp generator comprises a second common node to apply a third voltage reference. Furthermore, the voltage ramp generator may comprise a second portion of the capacitors of the array of capacitors. The respective second node of the second portion of the capacitors is connected to the second common node.

That means that the respective first node of the second portion of the capacitors which is coupled to the respective upper plate of the second portion of the capacitors is connected to the output node, and the respective second node of the second portion of the capacitors which is coupled to the respective bottom plate of the second portion of the capacitors, is connected to the second common node. In conclusion, the second portion of the capacitors is connected in parallel between the output node and the second common node. The third voltage reference may be a ground potential.

According to an embodiment, the voltage ramp generator comprises a buffer circuit to apply one of the first voltage reference and the second voltage reference to the common node. This configuration enables the first voltage reference or the second voltage reference to be applied to the common node by using only one buffer circuit.

According to an embodiment, the voltage ramp generator comprises a first controllable switch and a second controllable switch. The buffer circuit has an input side being connected to the first and second controllable switch to selectively apply one of the first voltage reference and the second voltage reference to the input side of the buffer circuit, and an output side being connected to the common node.

This configuration allows the first voltage reference or the second voltage reference to be selectively coupled to the input side of the buffer circuit. In conclusion, depending on the operation state of the controllable switch, the first voltage reference or the second voltage reference is applied to the common node, and thus to the respective second node of the portion of capacitors.

According to an embodiment, the voltage ramp generator comprises a controllable switch connected to the common node. The buffer circuit has an input side connected to the first voltage reference, and an output side connected to the controllable switch. This configuration of the voltage ramp generator enables the first voltage reference to be applied to the common node by operating the controllable switch in a closed, i.e. conductive, state.

According to an embodiment, the voltage ramp generator comprises a second controllable switch connected to the common node to apply the second voltage reference to the common node. The first controllable switch and the second controllable switch thus enable an offset to be created in the voltage ramp by initializing the ramp voltage at the start of the ramp to two different voltage references.

According to an embodiment, the voltage ramp generator comprises a second controllable switch being connected to the common node. The voltage ramp generator further comprises a second buffer circuit having an input side being connected to the second voltage reference, and an output side being connected to the second controllable switch. The second controllable switch enables the second voltage reference to be applied to the common node, and thus to the respective second node of the portion of the capacitors. An appropriate timing of the first and second controllable switch enables an offset to be created in the voltage ramp by initializing the ramp voltage to two different first and second voltage references.

According to an embodiment, the voltage ramp generator comprises a plurality of controllable switches. The second node of a respective one of the capacitors of the array of capacitors is connected to a first side of a respective one of the plurality of controllable switches. The voltage ramp generator further comprises a buffer circuit having an input side being connected to the first voltage reference, and an output side being connected to a respective second side of the plurality of the controllable switches to apply the first voltage reference to the respective second node of the capacitors. This configuration enables the selection of a desired number of capacitors to be connected to the first voltage reference.

According to an embodiment, the voltage ramp generator comprises a plurality of second controllable switches. The second node of a respective one of the capacitors of the array of capacitors is connected to a first side of a respective one of the plurality of the second controllable switches to apply the second voltage reference to the respective second node of the capacitors. This configuration enables to control the number of capacitors to be connected to the second voltage reference.

According to another embodiment, the voltage ramp generator comprises a plurality of second controllable switches. The second node of a respective one of the capacitors of the array of capacitors is connected to a first side of a respective one of the plurality of the second controllable switches. The voltage ramp generator further comprises a second buffer circuit having an input side being connected to the second voltage reference, and an output side being connected to a respective second side of the plurality of the second controllable switches to apply the second voltage reference to the respective second node of the capacitors.

This configuration enables to control of the number of capacitors to be connected to the second voltage reference.

The second voltage reference may be a ground or supply potential.

According to an embodiment, the voltage ramp generator comprises a third controllable switch to apply a third reference voltage to the output node. The third controllable switch enables the ramp voltage to be initialized before injecting an offset and increasing the voltage ramp.

An embodiment of an image sensor having reduced conversion time of a ramp analog-to-digital converter is specified in claim 15.

The image sensor comprises a pixel cell array that comprises a pixel cell being coupled to a column readout lines. The image sensor further comprises a ramp analog-to-digital converter being coupled to the column readout line, and a voltage ramp generator with low-noise offset injection, as specified above. The ramp analog-to-digital converter is configured to convert an analog signal of the pixel cell to a digital pixel value.

Additional features and advantages of the voltage ramp generator are set forth in the detailed description that follows. It is to be understood that both the foregoing general description and the following detailed description are merely exemplary, and are intended to provide an overview or framework for understanding the nature and character of the claims.

### Brief Description of the Drawings

The accompanying drawings are included to provide further understanding, and are incorporated in, and constitute a part of, the specification. As such, the disclosure will be more fully understood from the following detailed description, taken in conjunction with the accompanying figures in which:
Figure 1 shows a voltage ramp having a first slope to convert a "reset voltage" and a second slope to convert a "signal voltage" of an image sensor to a respective digital value;
Figure 2 shows a timing diagram of control signals of controllable switches of a voltage ramp generator, and courses of voltage ramps to convert a "reset voltage" and a "signal voltage" of an image sensor;
Figure 3A shows a first embodiment of a voltage ramp generator to create an offset of a ramp voltage;
Figure 3B shows a second embodiment of a voltage ramp generator to create an offset of a ramp voltage;
Figure 4 shows a first embodiment of a voltage ramp generator with low-noise offset injection;
Figure 5 shows a timing diagram of controllable switches to control controllable switches of the first embodiment of a voltage ramp generator with low-noise offset injection, and a course of a voltage ramp having an injected offset at the beginning of the slope of the "signal voltage" ramp;
Figure 6 shows a second embodiment of a voltage ramp generator with low-noise offset injection;
Figure 7 shows a third embodiment of a voltage ramp generator with low-noise offset injection;
Figure 8 shows a fourth embodiment of a voltage ramp generator with low-noise offset injection;
Figure 9 shows a fifth embodiment of a voltage ramp generator with low-noise offset injection;
Figure 10 shows an image sensor comprising a voltage ramp generator with low-noise offset injection; and
Figure 11 illustrates a possibility to shift a range of an analog-to-digital converter to convert a specific pixel output range at high gain.

### Detailed description of the embodiments

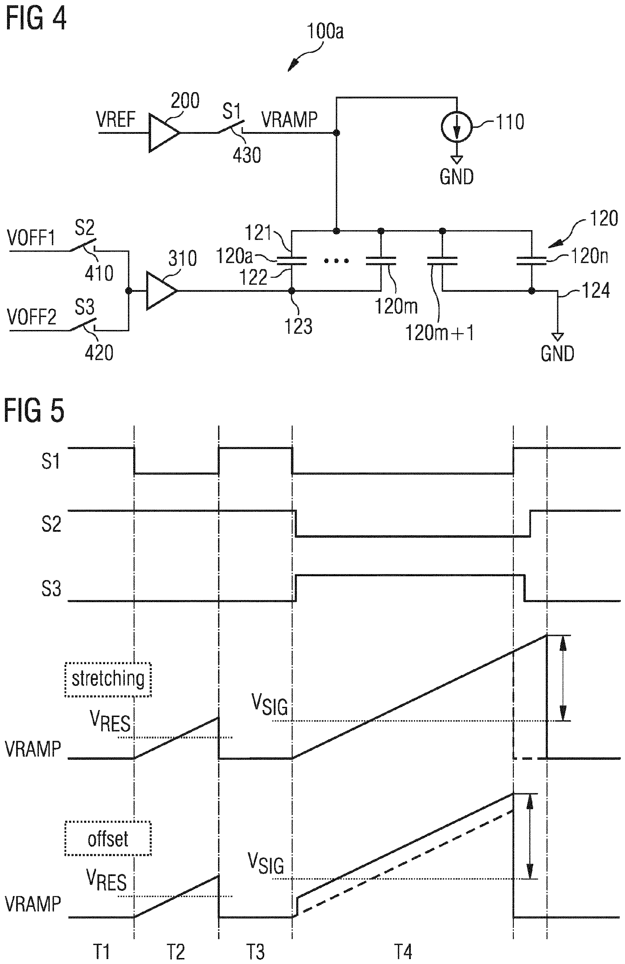

Figure 4 shows a first embodiment of a voltage ramp generator 100a with low-noise offset injection comprising an output node O to output an output voltage VRAMP. The voltage ramp generator 100a comprises a current source 110 coupled to the output node O. Furthermore, the voltage ramp generator 100a comprises an array of capacitors 120. Each of the capacitors 120a, ..., 120n has a respective first node 121 being coupled to the output node O, and a respective second node 122. The voltage ramp generator 100a is configured to selectively couple the respective second node 122 of at least a portion of the capacitors 120a, ..., 120m of the array of capacitors 120 to one of a first voltage reference VOFF1 and a second voltage reference VOFF2. In particular, the voltage ramp generator 100a is configured to selectively couple the capacitors 120a,..., 120m to one of the first voltage reference VOFF1 and the second voltage reference VOFF2.

The voltage ramp generator 100a comprises a first common node 123 of the portion of capacitors 120a,..., 120m. The respective second node 122 of the portion of the capacitors 120a, ..., 120m is connected to the first common node 123. The first common node 123 is arranged to apply one of the first voltage reference VOFF1 and the second voltage reference VOFF2. The portion of the capacitors 120a, ..., 120m is connected in parallel between the output node O and the first common node 123.

The voltage ramp generator 100a comprises a second common node 124 to apply a third voltage reference, for example a ground potential. Furthermore, the voltage ramp generator 100a comprises a second portion of capacitors 120m+1, ..., 120n of the array of capacitors 120. The respective second node 122 of the second portion of the capacitors 120m+1, ..., 120m is connected to the second common node 124.

The voltage ramp generator 100a comprises a buffer circuit 310 to apply one of the first voltage reference VOFF1 and the second voltage reference VOFF2 to the common node 123. The voltage ramp generator 100a further comprises a first controllable switch 410 that is controlled by a control signal S1, and a second controllable switch 420 that is controlled by a control signal S2. The buffer circuit 310 has an input side being connected to the first and second controllable switch 410, 420 to selectively apply one of the first voltage reference VOFF1 and the second voltage reference VOFF2 to the input side of the buffer circuit 310, and an output side being connected to the common node 123.

The voltage ramp generator 100a comprises a third controllable switch 430 to apply a third reference voltage VREF to the output node O. The third controllable switch is controlled by the control signal S1. The voltage ramp generator 100a further comprises a buffer circuit 200 having an input side to receive the third reference voltage VREF and an output side coupled via the third controllable switch 430 to the output node O.

Figure 5 shows a timing diagram to control the first, second and third controllable switch 410, 420 and 430 of the voltage ramp generator 100a by control signals S1, S2, S3 to generate an output signal VRAMP at the output node O during the first initialization phase T1, the voltage ramp during the reset phase T2, the output signal VRAMP during the second initialization phase T3, and the voltage ramp during the light-sensitive phase T4 of a pixel cell. In order to initialize the ramp voltage VRAMP to a voltage value VREF1 during the first initialization phase T1, the controllable switches 410 and 430 are operated in a conductive state. After operating the controllable switch 430 in a nonconductive state, the ramp voltage VRAMP increases during the reset phase T2. An offset jump is created before starting to increase the ramp voltage for the light-sensitive phase T4 by operating the controllable switches 410, 430 in a nonconductive state, and operating the controllable switch 420 in a conductive state. After injection of the offset jump at the beginning of the light-sensitive phase, the ramp voltage VRAMP increases during the light-sensitive phase T4 of the pixel cell.

In conclusion, the proposed voltage ramp generator allows an offset to be injected in the voltage ramp during the light-sensitive phase of a pixel cell of an image sensor by using only a part of the available capacitors, i.e. the capacitors 120a,..., 120m of the array of capacitors, to be connected to the first or second voltage reference VOFF1, VOFF2, and changing the voltage reference VOFF1, VOFF2 after the initialization of the ramp voltage. Since only a part of the capacitors of the array 120 is used to create the offset at the beginning of the second ramp during the light-sensitive phase T4 of the pixel cell, the voltage difference between the two voltage references VOFF1, VOFF2 is attenuated by the ratio of the portion of the capacitors 120a, ..., 120m and the second portion of the capacitors 120m+1, ..., 120n not coupled to the first or second voltage reference VOFF1, VOFF2.

That means that the noise on the voltage references is attenuated by this same ratio m/n. Moreover, providing the voltage references VOFF1 and VOFF2 with a large difference and providing the array of capacitors with a small ratio of m/n allows to get a relatively small offset change on the output voltage VRAMP. The settling of the voltage references VOFF1 and VOFF2 is relaxed, because the settling error is also divided by the ratio m/n.

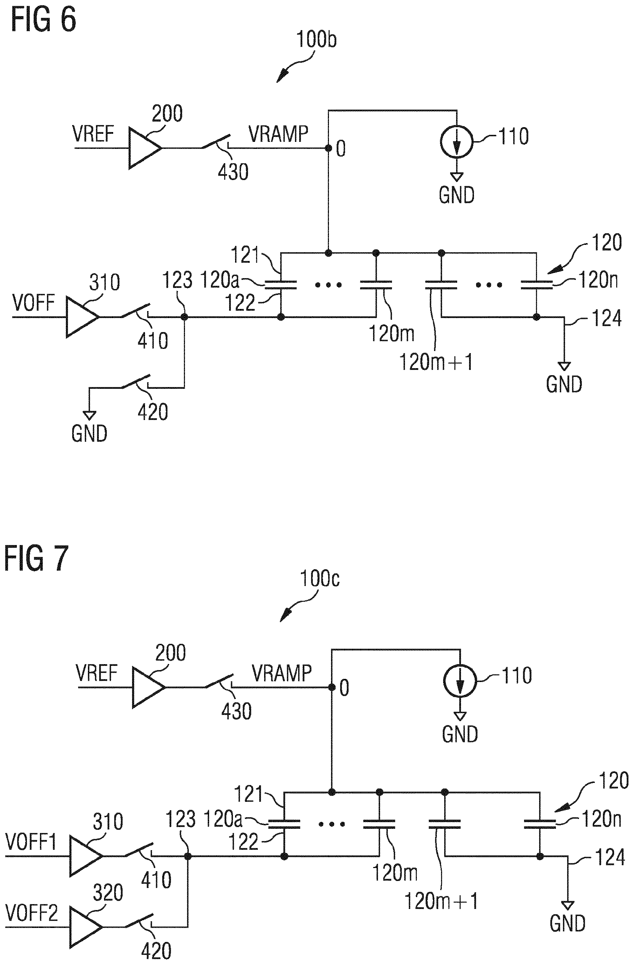

Figures 6 to 9 show further embodiments of a voltage ramp generator with low-noise offset injection by selecting only a small fraction of the capacitors of the array of capacitors 120 to actually add the offset in the ramp voltage.

Referring to the embodiments of a voltage ramp generator 100b and 100c shown in Figures 6 and 7, the voltage generator 100b, 100c comprises an output node O to output an output voltage VRAMP, a current source 110 coupled to the output node O, and an array of capacitors 120. Each of the capacitors 120a, ..., 120n has a respective first node 121 being coupled to the output node O, and a respective second node 122. The voltage ramp generator 100b, 100c is configured to selectively couple the respective second node 122 of at least a portion of the capacitors 120a, ..., 120m of the array of capacitors 120 to one of the first voltage reference VOFF, VOFF1 and the second voltage reference GND, VOFF2.

The voltage ramp generators 100b, 100c comprise a first common node 123 of the portion of the capacitors 120a, ..., 120m. The respective second node 122 of the portion of the capacitors 120a, ..., 120m is connected to the first common node 123. The first common node 123 is arranged to apply one of the first voltage reference VOFF, VOFF1 and the second voltage reference GND, VOFF2. As illustrated in Figures 6 and 7, the portion of the capacitors 120a, ..., 120m is connected in parallel between the output node O and the first common node 123.

The voltage ramp generators 100b, 100c comprise a second common node 124 to apply a third voltage reference, for example a ground potential. The voltage ramp generators 100b, 100c further comprise a second portion of capacitors 120m+1, ..., 120n of the array 120 of capacitors. The respective second node 122 of the second portion of the capacitors 120m+1, ..., 120n is connected to the second common node 124. The voltage ramp generators 100b, 100c comprise a controllable switch 430 to apply a reference voltage VREF to the output node O via a buffer 200.

Referring to the embodiment shown in Figure 6, the voltage ramp generator 100b comprises a controllable switch 410 being connected to the common node 123. The buffer circuit 310 has an input side being connected to the first voltage reference VOFF, and an output side being connected to the controllable switch 410. The voltage ramp generator 100b comprises a second controllable switch 420 being connected to the common node 123 to apply the second voltage reference, for example a ground potential GND or a supply potential, to the common node 123. In the embodiment of the voltage ramp generator 100b, the offset jump in the voltage ramp is generated by switching between the first voltage reference VOFF and the second voltage reference, i.e. a ground or supply potential.

Referring to the embodiment of the voltage ramp generator 100c shown in Figure 7, the voltage ramp generator 100c comprises a controllable switch 410 being connected to the common node 123. The buffer circuit 310 has an input side being connected to the first voltage reference VOFF1, and an output side being connected to the controllable switch 410. The voltage ramp generator 100b comprises a second controllable switch 420 being connected to the common node 123. The voltage ramp generator 100c further comprises a second buffer circuit 320 having an input side being connected to the second voltage reference VOFF2, and an output side being connected to the second controllable switch 420. In the embodiment of the voltage ramp generator 100c the offset jump in the voltage ramp is generated by choosing buffer circuits 310 and 320 to apply the first or second voltage reference VOFF1, VOFF2 to the common node 123.

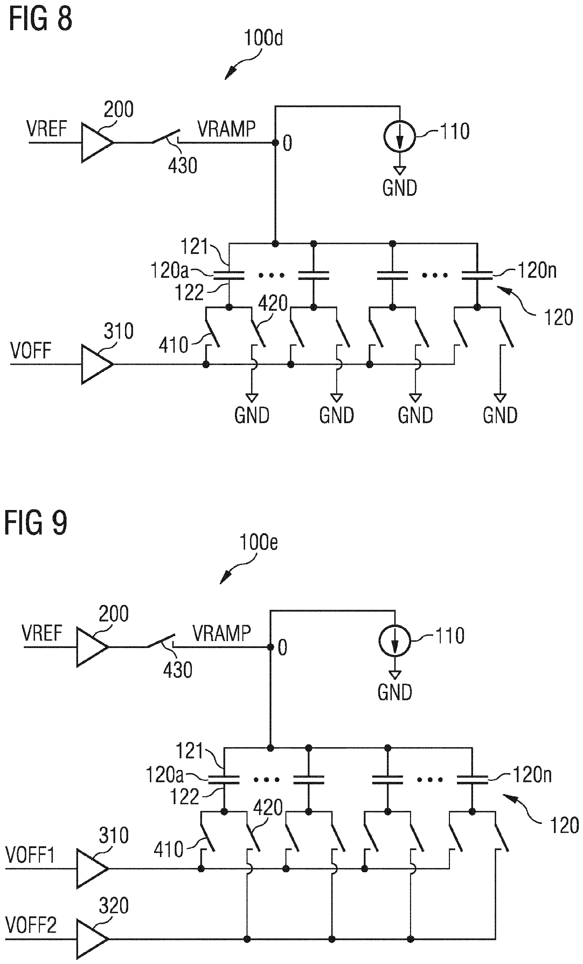

Figures 8 and 9 show further embodiments of a voltage ramp generator 100d and 100e with low-noise offset injection comprising an output node O to output an output voltage VRAMP, a current source 110 coupled to the output node O, and an array of capacitors 120. Each of the capacitors 120a, ..., 120n of the array of capacitors 120 has a respective first node 121 being coupled to the output node O, and a respective second node 122. The voltage ramp generator 100d, 100e is configured to selectively couple the respective second node 122 of at least a portion of the capacitors of the array of capacitors 120 to one of a first voltage reference VOFF, VOFF1 and a second voltage reference GND, VOFF2.

Referring to the embodiments of the voltage ramp generator 100d and 100e, the voltage ramp generators comprise a controllable switch 430 to apply a third reference voltage VREF to the output node O, and a buffer circuit 200 having an input side being coupled to the third reference voltage VREF and the controllable switch 430.

The voltage ramp generators 100d, 100e comprise a plurality of controllable switches 410. The second node 122 of a respective one of the capacitors 120a,..., 120n of the array of capacitors 120 is connected to a first side of a respective one of the plurality of controllable switches 410. The voltage ramp generators 100d, 100e further comprise a buffer circuit 310 having an input side being connected to the first voltage reference VOFF, VOFF1, and an output side being connected to a respective second side of the plurality of the controllable switches 410 to apply the first voltage reference VOFF, VOFF1 to the respective second node 122 of the capacitors 120a,..., 120n.

Referring to the embodiment of the voltage ramp generator 100d shown in Figure 8, the voltage ramp generator 100d comprises a plurality of second controllable switches 420. The second node 122 of a respective one of the capacitors 120a,..., 120n of the array of capacitors 120 is connected to a first side of a respective one of the plurality of the second controllable switches 420 to apply the second voltage reference, for example a ground potential GND or a supply potential, to the respective second node 122 of the capacitors 120a,..., 120n.

Referring to the embodiment of the voltage ramp generator 100d shown in Figure 8, an offset jump is generated in the voltage ramp by switching between the first voltage reference VOFF and the second voltage reference, i.e. a ground or supply potential. The impact of noise of the controllable switches may be chosen by controlling the number of capacitors to be connected to the first or second voltage reference. The embodiment of the voltage ramp generator 100d has the advantage that the ratio between the capacitors to be switched/connected to the first voltage reference and the remainder of the capacitors to be connected to the second voltage reference can be determined by the first and second controllable switches.

Referring to the embodiment of the voltage ramp generator 100e shown in Figure 9, the voltage ramp generator 100e comprises a plurality of second controllable switches 420. The second side 122 of a respective one of the capacitors 120a,..., 120n of the array of capacitors 120 is connected to a first side of a respective one of the plurality of the second controllable switches 420. The voltage ramp generator 100e comprises a second buffer circuit 320 having an input side being connected to the second voltage reference VOFF2, and an output side being connected to a respective second side of the plurality of the second controllable switches 420 to apply the second voltage reference VOFF2 to the respective second node 122 of the capacitors 120a,..., 120n.

According to the embodiment of the voltage ramp generator 100e shown in Figure 9, an offset jump is generated in the voltage ramp by choosing the first or second buffer circuit 310, 320 to be connected to the second node 122 of a respective one of the capacitors 120a,..., 120n. The impact of noise of the controllable switches can be chosen by controlling the number of capacitors to be connected to the first or second voltage reference.

All the proposed embodiments of a voltage ramp generator use the capacitors that are already needed to create a ramp signal, but by connecting and timing them in a novel way a reliable jump in the ramp can be achieved. The normal noise impact of the switching references is attenuated by selecting only a small fraction of the capacitors to actually add the offset.

The embodiments of voltage ramp generators 100a, ...,100e can be used in an image sensor to convert an analog signal of a pixel cell to a digital pixel value by means of a ramp analog-to-digital converter.

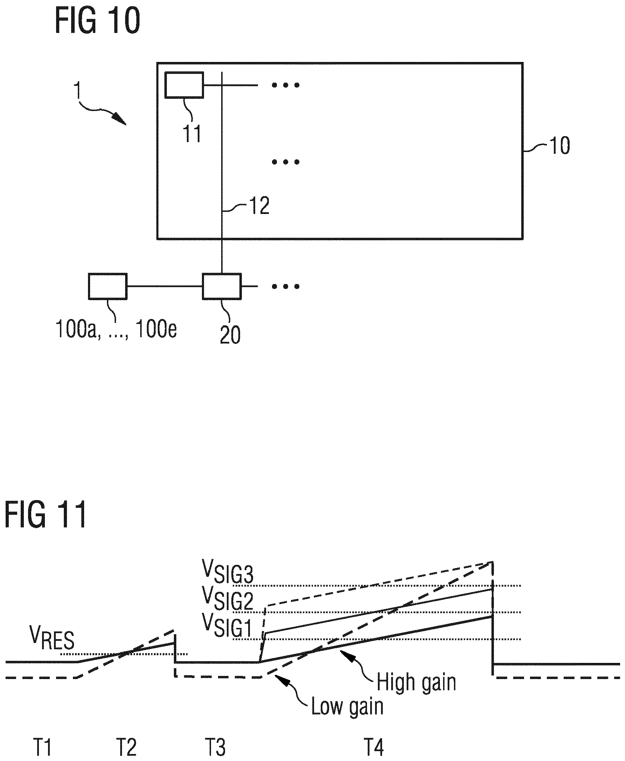

Figure 10 shows a simplified illustration of an image sensor 1 comprising a pixel cell array 10. The pixel cell array 10 comprises a pixel cell 11 being coupled to a column readout line 12. The image sensor 1 comprises a ramp analog-to-digital converter 20 being coupled to the column readout line 12, and a voltage ramp generator according to one of the embodiments 100a,...,100d being coupled to the ramp analog-to-digital converter 20. The ramp analog-to-digital converter 20 is configured to convert an analog signal of the pixel cell 11 to a digital pixel value by comparing the signal voltage on the column readout line 12 during a light-sensitive phase of the pixel cell 11 with the ramp voltage generated by the voltage ramp generator 100a,..., 100d.

The proposed embodiments of a voltage ramp generator 100a,..., 100e allow a reliable, low-noise jump to be created in the global ramp of the voltage ramp generator to reduce conversion time of a ramp analog-to-digital converter. A single, simple timing change at the start of one of the ramps allows an offset to be injected with minimal added noise. The offset injection reduces conversion "dead" time. The voltage ramp generators 100a, ..., 100e allow to drastically reduce noise contribution of the changed reference. The proposed embodiments of the voltage ramp generators 100a,..., 100e can be used for both a positive or a negative dark offset.

Referring to Figure 11, an offset injection can further be used to shift the ADC range so that only a specific pixel output range is converted at high gain. Figure 11 shows different offset injections at the start of the "signal voltage" ramp during the light-sensitive phase T4. Different pixel output ranges can be selected for high gain conversion. This allows to have high gain in the high output range of a pixel. In the case of a conventional ramp generator, as illustrated in Figures 3A or 3B, this would need a very long conversion to capture the full pixel range.

The embodiments of the voltage ramp generator and the image sensor disclosed herein have been discussed for the purpose of familiarizing the reader with novel aspects of the design of the voltage ramp generator and the image sensor. Although preferred embodiments have been shown and described, many changes, modifications, equivalents and substitutions of the disclosed concepts may be made by one having skill in the art without unnecessarily departing from the scope of the claims.

In particular, the design of the voltage ramp generator and the image sensor is not limited to the disclosed embodiments, and gives examples of many alternatives as possible for the features included in the embodiments discussed. However, it is intended that any modifications, equivalents and substitutions of the disclosed concepts be included within the scope of the claims which are appended hereto.

Features recited in separate dependent claims may be advantageously combined. Moreover, reference signs used in the claims are not limited to be construed as limiting the scope of the claims.

Furthermore, as used herein, the term "comprising" does not exclude other elements. In addition, as used herein, the article "a" is intended to include one or more than one component or element, and is not limited to be construed as meaning only one.

### References

- 1: image sensor
- 10: pixel cell array
- 11: pixel cell
- 12: column readout line
- 20: ramp analog-to-digital converter
- 100a,...,100e: voltage ramp generator
- 110: current source
- 120: array of capacitors
- 120a,...,120n: capacitors
- 200,210,220: buffer circuit
- 310,320: buffer circuit
- 410,...,430: controllable switch

## Claims

1. A voltage ramp generator with low-noise offset injection, comprising:
- an output node (O) to output an output voltage (VRAMP) of the voltage ramp generator,
- a current source (110) coupled to the output node (O),
- an array of capacitors (120), each of the capacitors (120a,..., 120n) having a respective first node (121) being coupled to the output node (O), and a respective second node (122),
- wherein the voltage ramp generator is configured to selectively couple the respective second node (122) of at least a portion of the capacitors (120a, ..., 120m) of the array of capacitors (120) to one of a first voltage reference (VOFF, VOFF1) and a second voltage reference (GND, VOFF2).

2. The voltage ramp generator of claim 1, comprising
- a first common node (123) of the portion of the capacitors (120a, ..., 120m), wherein the respective second node (122) of the portion of the capacitors is connected to the first common node (123),
- wherein the first common node (123) is arranged to apply one of the first voltage reference (VOFF, VOFF1) and the second voltage reference (GND, VOFF2).

3. The voltage ramp generator of claim 1 or 2, comprising:
- a second common node (124) to apply a third voltage reference (GND),
- a second portion of the capacitors (120m+1, ..., 120n) of the array of capacitors,
- wherein the respective second node (122) of the second portion of the capacitors (120m+1, ..., 120n) is connected to the second common node (124).

4. The voltage ramp generator of claim 3,
wherein the third voltage reference is a ground potential.

5. The voltage ramp generator of any of the claims 2 to 4, comprising:
a buffer circuit (310) to apply one of the first voltage reference (VOFF, VOFF1) and the second voltage reference (GND, VOFF2) to the common node (123).

6. The voltage ramp generator of claim 5, comprising:
- a first controllable switch (410) and a second controllable switch (420),
- wherein the buffer circuit (310) has an input side being connected to the first and second controllable switch (410, 420) to selectively apply one of the first voltage reference (VOFF1) and the second voltage reference (VOFF2) to the input side of the buffer circuit (310), and an output side being connected to the common node (123).

7. The voltage ramp generator of claim 5, comprising
- a controllable switch (410) being connected to the common node (123),
- wherein the buffer circuit (310) has an input side being connected to the first voltage reference (VOFF, VOFF1), and an output side being connected to the controllable switch (410) .

8. The voltage ramp generator of claim 7, comprising a second controllable switch (420) being connected to the common node (123) to apply the second voltage reference (GND) to the common node (123).

9. The voltage ramp generator of claim 7, comprising:
- a second controllable switch (420) being connected to the common node (123),
- a second buffer circuit (320) having an input side being connected to the second voltage reference (VOFF2), and an output side being connected to the second controllable switch (420) .

10. The voltage ramp generator of claim 1, comprising:
- a plurality of controllable switches (410), wherein the second node (122) of a respective one of the capacitors (120a, ..., 120n) of the array of capacitors (120) is connected to a first side of a respective one of the plurality of controllable switches (410),
- a buffer circuit (310) having an input side being connected to the first voltage reference (VOFF1), and an output side being connected to a respective second side of the plurality of the controllable switches (410) to apply the first voltage reference (VOFF1) to the respective second node (122) of the capacitors (120a, ..., 120n).

11. The voltage ramp generator of claim 10, comprising
- a plurality of second controllable switches (420),
- wherein the second node (122) of a respective one of the capacitors (120a, ..., 120n) of the array of capacitors (120) is connected to a first side of a respective one of the plurality of the second controllable switches (420) to apply the second voltage reference (GND) to the respective second node (122) of the capacitors (120a, ..., 120n).

12. The voltage ramp generator of claim 10, comprising
- a plurality of second controllable switches (420), wherein the second node (122) of a respective one of the capacitors (120a, ..., 120n) of the array of capacitors (120) is connected to a first side of a respective one of the plurality of the second controllable switches (420),
- a second buffer circuit (320) having an input side being connected to the second voltage reference (VOFF2), and an output side being connected to a respective second side of the plurality of the second controllable switches (420) to apply the second voltage reference (VOFF2) to the respective second node (122) of the capacitors (120a, ..., 120n).

13. The voltage ramp generator of claim 8 or 11,
wherein the second voltage reference is a ground or supply potential.

14. The voltage ramp generator of any of the claims 1 to 13, comprising:
a third controllable switch (420) to apply a third reference voltage (VREF) to the output node (O).

15. An image sensor, comprising:
- a pixel cell array (10) comprising a pixel cell (11) being coupled to a column readout line (12),
- a ramp analog-to-digital converter (20) being coupled to the column readout line (12),
- a voltage ramp generator (100a, ..., 100d) of any of the claims 1 to 14 being coupled to the ramp analog-to-digital converter (20),
- wherein the ramp analog-to-digital converter (20) is configured to convert an analog signal of the pixel cell (11) to a digital pixel value.
